# EUROPÄISCHE PATENTANMELDUNG

(11) **EP 1 950 410 A2**
(43) Veröffentlichungstag der Anmeldung: **30.07.2008**
(21) Anmeldenummer: 08100035.8
(22) Anmeldetag: 03.01.2008
(51) Int. Cl.: F02M 51/06, F02M 61/16, F02M 63/00, H01L 41/00

(54) **Injektor mit piezoelektrischem Aktuator**

(30) Priorität: 29.01.2007 DE 102007004380
(71) Anmelder: ROBERT BOSCH GMBH, 70442 Stuttgart (DE)
(72) Erfinder: Kiontke, Martin, 70825, Korntal-Muenchingen (DE); Ferraro, Giovanni, 71642, Ludwigsburg (DE)

(57) **Zusammenfassung**

Die Erfindung betrifft einen Injektor (1) zum Einspritzen von Kraftstoff in Brennräume von Brennkraftmaschinen, piezoelektrischen Aktuatoreinheit (2) mit einem Aktuatorkopf (5) und mit einem eine erste Aktuatorfußfläche (12) aufweisenden Aktuatorfuß (4), der sich mit einer axial an die erste Aktuatorfußfläche (12) angrenzenden Aktuatorfußkontaktfläche (14) an einer Haltekörperkontaktfläche (20) eines Haltekörpers (3) mit einer axial an die Haltekörperkontaktfläche (20) angrenzenden ersten Innenfläche (17) zur zur Abdichtung eines Kabelabgangs (8) abstützt, wobei zwischen der ersten Aktuatorfußfläche (12) und der ersten Innenfläche (17) ein erster Winkel (α) aufgespannt ist. Erfindungsgemäß ist vorgesehen, dass die erste Innenfläche (17) an die vom Aktuatorkopf (5) abgewandte Axialseite (16) der Haltekörperkontaktfläche (20) und die erste Aktuatorfußfläche (12) an die vom Aktuatorkopf (5) abgewandte Axialseite (16) der Aktuatorfußkontaktfläche (14) anschließen.

## Beschreibung

### Stand der Technik

Die Erfindung betrifft einen Injektor, insbesondere einen Common-Rail-Injektor gemäß dem Oberbegriff des Anspruchs 1.

Die DE 103 26 259 A1 zeigt einen Injektor für Kraftstoff-Einspritzsysteme von Brennkraftmaschinen mit einer piezoelektrischen Aktuatoreinheit, die mit ihrem Aktuatorfuß gegen einen Haltekörper federkraftbelastet ist. Der Aktuatorfuß liegt dabei mit einer unmittelbar am oberen Ende des Aktuatorfußes bzw. der piezoelektrischen Aktuatoreinheit angeordneten Aktuatorfußkontaktfläche an der kegelförmigen Innenseite des Haltekörpers an. Bei dem bekannten Injektor ist die piezoelektrische Aktuatoreinheit innerhalb eines von unter Hochdruck stehendem Kraftstoff durchflossenen Druckraum angeordnet, der durch die Anlage der Aktuatorfußkontaktfläche an der Innenseite des Haltekörpers gegenüber einer Anschlusskabelbohrung zur elektrischen Kontaktierung der piezoelektrischen Aktuatoreinheit abgedichtet ist.

Bei dem aus der DE 103 46 242 A1 bekannten Injektor wird der Kabelabgang zu einer piezoelektrischen Aktuatoreinheit über kegelförmige Kontaktflächen am Aktuatorfuß und am Haltekörper abgedichtet. Der metallische Kontaktsitz wirkt nicht (ausreichend) als Dichtsitz, wodurch eine O-Ringdichtung radial zwischen dem Aktuatorfuß und dem Haltekörper positioniert werden muss, um ein Austreten von Kraftstoff in dem Kabelabgang zu verhindern.

Auch die DE 103 22 673 A1 zeigt einen Injektor mit einer piezoelektrischen Aktuatoreinheit, wobei radial zwischen dem Aktuatorfuß und dem Haltekörper eine O-Ringdichtung angeordnet ist. Bei dem bekannten Injektor liegt der Aktuatorfuß mit einer kugelförmigen Fläche an einer kegelförmigen Fläche des Haltekörper an. Die erwähnte O-Ringdichtung wird benötigt, da der metallische Kontaktsitz aufgrund einer in der Praxis nicht realisierbaren umlaufenden Anlage des Aktuatorfußes am Haltekörper sowie aufgrund von im Betrieb auftretenden Schwingungen, die zu Mikrobewegungen an der Kontaktstelle führen nicht (ausreichend) als Dichtsitz wirkt.

Während des Montageprozesses kann es zu einem erhöhten Ausschuss aufgrund von Beschädigungen der O-Ringdichtung in verschiedenen Montagevorrichtungen kommen. Zudem handelt es sich bei der O-Ringdichtung um ein zusätzliches Bauteil, dass die Montage erschwert und die Materialkosten erhöht.

### Offenbarung der Erfindung

### Technische Lösung

Der Erfindung liegt die Aufgabe zugrunde, einen Injektor vorzuschlagen, bei dem auf eine O-Ringdichtung zwischen dem Aktuatorfuß und dem Haltekörper zur Abdichtung des Kabelabgangs bei gleichzeitiger Gewährleistung einer ausreichenden Dichtigkeit des zur Anwendung kommenden Metalldichtsitzesverzichtet werden kann. Ferner besteht die Aufgabe darin, ein geeignetes Montageverfahren für einen Injektor bereitzustellen.

### Technische Lösung

Diese Aufgabe wird hinsichtlich des Injektors mit den Merkmalen des Anspruchs 1 gelöst. Hinsichtlich des Montageverfahrens wird die Aufgabe mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren offenbarten Merkmale.

Der Erfindung liegt der Gedanke zugrunde, lediglich einen metallischen Dichtsitz zwischen dem Akturatorfuß und dem Haltekörper vorzusehen und die im montierten Zustand an der Haltekörperkontaktfläche anliegende Aktuatorfußkontaktfläche mit Abstand zum (oberen) axialen Ende der piezoelektrischen Aktuatoreinheit, also unterhalb von diesem, anzuordnen. Dies wird dadurch erreicht, dass die erste Innenfläche des Haltekörpers und die gegenüberliegende erste Aktutorfußfläche des Aktuatorfußes einen ersten Winkel α aufspannen, der sich nach oben hin, also in Richtung von dem dem Aktuatorfuß gegenüberliegenden Aktuatorkopf weg öffnet. Bevorzugt öffnet sich der erste Winkel α sowohl axial nach oben als auch nach radial innen in Richtung der gedachten Längsmittelachse der piezoelektrischen Aktuatoreinheit. Anders ausgedrückt befinden sich die erste Innenfläche des Haltekörpers und die erste Aktuatorfußkontaktfläche des Aktuatorfußes oberhalb der Haltekörperkontaktfläche sowie oberhalb der insbesondere formkongruent zu dieser ausgebildeten Akturatorfußkontaktfläche. Aufgrund der axialen Beabstandung der Kontaktflächen von dem axialen Ende des Aktuatorfußes kann eine exaktere Einpassung der piezoelektrischen Aktuatoreinheit in den Haltekörper gewährleistet werden. Ferner kann aufgrund der verbesserten Dichtwirkung auf eine O-Ringdichtung zwischen dem Aktuatorfuß und dem Haltekörper verzichtet werden, wodurch die Bauteilanzahl reduziert wird und gleichzeitig der Ausschuss während der Montage minimiert wird. Zudem wird die Handhabung des Injektors bei der Montage vereinfacht.

Bevorzugt ist die piezoelektrische Aktuatoreinheit des Injektors nicht in einem unter Raildruck stehenden Druckraum des Injektors, sondern in einem Niederdruckbereich eines servoventilgesteuerten Injektors mit Drücken unter 100 bar, vorzugsweise unter 60 bar angeordnet. Hierzu wird die Versorgungsleitung des Injektors, die diesen bevorzugt aus einem Kraftstoffhochdruckspeicher (Rail) mit unter Hochdruck stehendem Kraftstoff versorgt an der Aufnahmekammer für die piezoelektrische Aktuatoreinheit vorbeigeführt. Selbstverständlich ist es möglich, die Erfindung auch bei einem Injektor mit direkter Nadelsteuerung einzusetzen, bei dem kein Niederdruckbereich existiert und der (geschützte) Aktuator von mit unter Raildruck stehendem Kraftstoff umspült ist.

Von besonderem Vorteil ist es, wenn der Aktuatorfuß und der Haltekörper ausschließlich an linienförmigen, insbesondere kreislinienförmigen Kontaktflächen aneinander anliegen. Durch die linienförmige Lagerung kommt es zwischen beiden Bauteilen zu einer sehr hohen Flächenpressung, wodurch eine optimale hydraulische Abdichtung realisiert werden kann. Bevorzugt werden während der Montage des Injektors Vorspannkräfte auf die Bauteile aufgebracht, die größer sind als die maximal im Betrieb auftretenden Kräfte, wodurch sich die Kontaktgeometrien aneinander anpassen, d.h. mögliche Fertigungstoleranzen, wie beispielsweise Oberflächenrauhigkeiten und/oder Formabweichungen ausgeglichen werden. Dies erhöht die hydraulische Dichtigkeit der metallischen Dichtverbindung.

Fertigungstechnisch von Vorteil ist es, wenn die erste Aktuatorfußfläche und die erste Innenfläche sich konisch verjüngend ausgebildet sind, also als Kegelflächen ausgeformt sind. Die Haltekörperkontaktfläche bzw. die Aktuatorfußkontaktfläche befinden sich dabei am Fuße dieser Kegelflächen.

In Weiterbildung der Erfindung ist mit Vorteil vorgesehen, dass die Aktuatorfußkontaktfläche axial zwischen der ersten Aktuatorfußfläche und einer sich in Richtung des Aktuatorkopfes erstreckenden zweiten Aktuatorfußfläche angeordnet ist, also von einer umlaufenden Berührungskante der winklig zueinander angeordneten, in axialer Richtung benachbarten und sich in Umfangsrichtung erstreckenden Aktuatorfußflächen gebildet ist. Analog weist der Haltekörper mit Vorteil eine zweite Innenfläche auf, die winklig zur ersten Innenfläche angeordnet ist und die zusammen eine umlaufende Berührungskante bilden, welche der Haltekörperkontaktfläche entspricht. Die zweite Innenfläche und die zweite Aktuatorfußfläche sind dabei auf der dem Aktuatorkopf zugewandeten Axialseite der Haltekörperkontaktfläche angeordnet und spannen einen zweiten Winkel β, der sich in Richtung des Aktuatorkopfes, also etwa in eine der Öffnungsrichtung des ersten Winkels α entgegengesetzte Richtung öffnet.

Es hat sich als vorteilhaft erwiesen, dass die zweite Aktuatorfußfläche mit der Längsmittelachse der Aktuatoreinheit einen spitzeren Winkel einschließt als die erste Aktuatorfußfläche und/oder das die erste Innenfläche des Haltekörpers einen spitzeren Winkel mit der Längsmittelachse der Aktuatoreinheit einschließt als die zweite Innenfläche. Hierdurch wird eine kreislinienförmige Kontaktgeometrie geschaffen, bei der die Kontaktflächen sowohl auf Seiten des Aktuatorfußes als auch auf Seiten des Haltekörpers von in radialer Richtung nach außen bzw. nach innen vorstehenden Kanten zwischen zwei jeweils in axialer Richtung benachbarten Umfangsflächen (erste Aktuatorfußfläche und zweite Aktuatorfußfläche, bzw. erste Innenfläche und zweite Innenfläche) gebildet werden.

Eine besonders gute Abdichtung wird erreicht, wenn der erste Winkel α zwischen der ersten Innenfläche und der ersten Aktuatorfußfläche etwa 10° beträgt und/oder der zweite Winkel β zwischen der zweiten Innenfläche und der zweiten Aktuatorfußfläche etwa 35° beträgt.

Um eine optimale hydraulische Abdichtung zwischen der piezoelektrischen Aktuatoreinheit und dem Haltekörper zu realisieren, schlägt das erfindungsgemäße Montageverfahren vor, dass der Haltekörper und die piezoelektrische Aktuatoreinheit bei der Montage mit einer Anpresskraft aneinander angepresst werden, die gewährleistet, dass die beiden auf dem gleichen Anlagedurchmesser liegenden umfangskantenförmigen Kontaktflächen aneinander angepasst werden und somit etwaige Oberflächenrauhigkeiten und Formabweichungen ausgeglichen werden. Gemäß dem erfindungsgemäßen Montageverfahren ist die hierzu aufzubringende Anpresskraft größer als die maximal im Betrieb des Injektors auf die piezoelektrische Aktuatureinheit in Richtung des Haltekörpers wirkende Kraft (Federkraft und/oder Druckkraft).

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung.

Die einzeige Figur zeigt eine unvollständige Darstellung eines Injektors.

### Ausführungsform der Erfindung

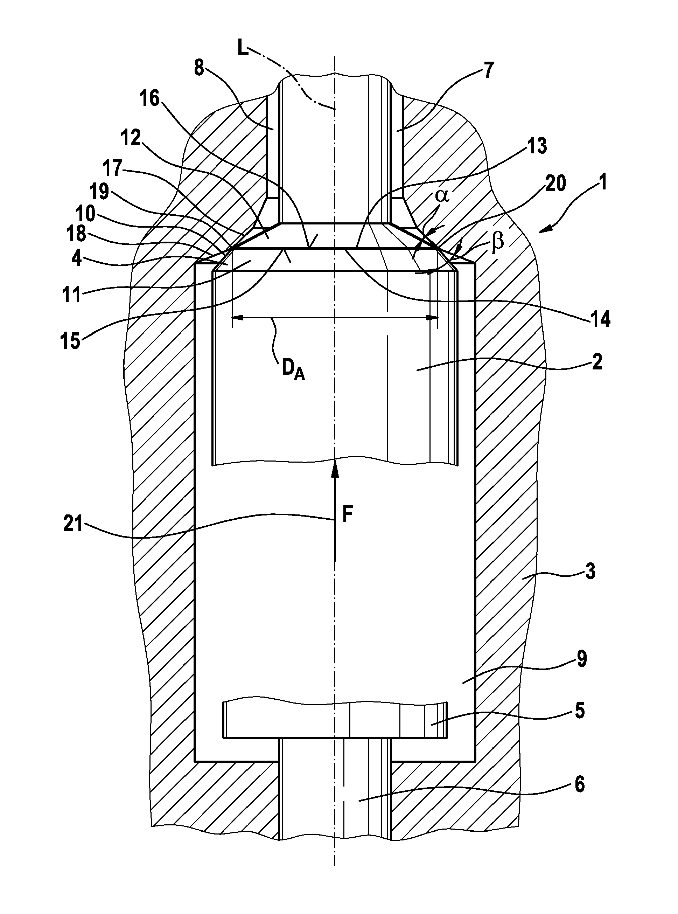

Fig. 1 zeigt ausschnittsweise einen Injektor 1 zum Einspritzen von Kraftstoff in Brennräume von Brennkraftmaschinenn. Bezüglich eines möglichen Gesamtaufbaus des Injektors wird auf die DE 10 2004 061 800 A1 (servoventilgesteuerter Injektor) und auf die DE 10 2004 005 452 A1 (Injektor und direkter Nadelsteuerung) verwiesen, die hiermit bezüglich der Anordnung der piezoelektrischen Aktuatoreinheit im Injektor bzw. bezüglich der Funktionsweise des Injektors zum Gegenstand der Offenbarung gemacht werden.

Der Injektor 1 ist mit einer piezoelektrischen Aktuatureinheit 2 ausgestattet, die in einem Haltekörper 3 (bzw. Injektorkörper) aufgenommen ist und die an ihrem in der Zeichnungsebene oberen Endbereich mit einem Aktuatorfuß 4 und gegenüberliegend mit einem Aktuatorkopf 5 ausgestattet ist. Der Aktuatorkopf 5 wirkt dabei in an sich bekannter Weise auf einen nur ausschnittsweise dargestellten Stellkolben 6, der entweder Teil eines Servoventils (servoventilunterstützter Injektor) oder Teil des eigentlichen Injektorventils (direkte Nadelsteuerung) ist. Im Ergebnis wird durch die Längenänderung des aus Schichten von piezoelektrischem Material aufgebauten piezoelektrischen Aktuators eine Düsennadel von ihrem Nadelsitz abgehoben, wodurch ein Kraftstofffluss durch eine nicht gezeigte Düsenlochanordnung in dem Brennraum einer Brennkraftmaschine freigeben wird, oder die Düsennadel wird auf den Nadelsitz gepresst, wodurch der Kraftstoffaustritt unterbunden wird. Der Aktuatorkopf 5 dient dabei zur Übertragung der Längenänderung (Längung oder Kontraktion) der piezoelektrischen Aktuatoreinheit auf den Stellkolben.

Die piezoelektrische Aktuatoreinheit 2 wird mittels einer nicht dargestellten Druckfeder in Richtung in der Zeichnungsebene nach oben mit ihrem Aktuatorfuß 4 gegen den Haltekörper 3 gepresst, wodurch eine Abdichtung eines als Kabelabgang 7 dienenden Kanals zur Aufnahme eines Anschlusskabels zur elektrischen Kontaktierung der piezoelektrischen Aktuatoreinheit 2 von dem mit Kraftstoff gefüllten Aufnahmeraum 9 realisiert wird.

Die in ihrem mittleren Bereich (piezoelektrische Schichten) kreiszylinderförmige piezoelektrische Aktuatoreinheit 2 verjüngt sich im Bereich ihres Aktuatorfußes 4 in der Zeichnungsebene nach oben, also in eine von dem Aktuatorkopf 5 abgewandte Richtung. Dieser Verjüngungsabschnitt 10 wird im Wesentlichen gebildet von einer unteren, als Umfangsfläche ausgebildeten zweiten Aktuatorfußfläche 11 und von einer in axialer Richtung daran anschließenden, ebenfalls als Umfangsfläche ausgebildeten ersten Aktuatorfußfläche 12. Beide Aktuatorfußflächen 11, 12 sind kegelförmig ausgeformt, wobei jedoch die untere, zweite Aktuatorfußfläche 11 mit der Längsmittelachse L der piezoelektrischen Aktuatoreinheit 2 einen spitzeren (Kegel-) Winkel einschließt als die obere, erste Aktuatorfußfläche 12, so dass zwischen beiden Aktuatorfußflächen 11, 12 eine sich in Umfangsrichtung erstreckende Kante 13 gebildet ist, welche wiederum als kreislinienförmige Aktuatorfußkontaktfläche 14 dient, mittels der der Aktuatorfuß 4 an dem Haltekörper 3 dichtend anliegt. Anders ausgedrückt schließt an der unteren, aktuatorkopfseitigen Axialseite 15 in axialer Richtung die zweite Aktuatorfußfläche 11 an. Weiterhin schließt gegenüberliegend in axialer Richtung an die dem Aktuatorkopf 5 abgewandte obere Axialseite 16 der Aktuatorfußkontaktfläche 14 die erste Aktuatorfußfläche 12 an.

Der ersten Ankerfußfläche 12 in radialer Richtung gegenüberliegend weist der Haltekörper 3 eine erste Innenfläche 17 auf, die mit der Längsmittelachse L der piezoelektrischen Aktuatoreinheit 2 einen spitzeren Winkel einschließt als eine in axialer Richtung benachbarte, untere zweite Innenfläche 18 des Haltekörpers 3. Von den beiden Innenflächen 17, 18 wird eine umlaufende Kante 19 gebildet, die als kreislinienförmige Haltekörperkontaktfläche 20 dient, und die dichtend an der formkongruenten, ebenfalls kreislinienförmigen Aktuatorfußkontaktfläche 14 anliegt. Der Anlagedurchmesser D_{A} der Kontaktflächen 14, 20 ist dabei identisch.

Die erste Innenfläche 17 spannt mit der ersten Aktuatorfußfläche 12 einen sich in der Zeichnungsebene nach oben sowie nach radial innen öffnenden Winkel α von in diesem Ausführungsbeispiel etwa 10° auf. Die zweite Innenfläche 18 und die gegenüberliegende zweite Aktuatorfußfläche 11 spannen im Wesentlichen in entgegengesetzter Richtung einen Winkel β nach axial unten und radial außen von in diesem Ausführungsbeispiel etwa 35° auf.

Bei der Montage wird beispielsweise der Haltekörper 3 fest eingespannt und die piezoelektrische Aktutoreinheit in Pfeilrichtung 21 in Richtung des Haltekörpers 3 beaufschlagt, also mit einer Anpresskraft F, die größer ist als die maximal in Betrieb in Pfeilrichtung 21 auftretende Kraft, so dass sich die kreislinienförmigen Kontaktflächen 20, 14 des Haltekörpers 3 und des Aktuatorfußes 4 aneinander anpassen, wodurch fertigungstechnisch bedingte Toleranzen ausgeglichen werden.

## Patentansprüche

1. Injektor (1) zum Einspritzen von Kraftstoff in Brennräume von Brennkraftmaschinen, mit einer piezoelektrischen Aktuatoreinheit (2) mit einem Aktuatorkopf (5) und mit einem eine erste Aktuatorfußfläche (12) aufweisenden Aktuatorfuß (4), der sich mit einer axial an die erste Aktuatorfußfläche (12) angrenzenden Aktuatorfußkontaktfläche (14) an einer Haltekörperkontaktfläche (20) eines Haltekörpers (3) mit einer axial an die Haltekörperkontaktfläche (20) angrenzenden ersten Innenfläche (17) zur Abdichtung eines Kabelabgangs abstützt, wobei zwischen der ersten Aktuatorfußfläche (12) und der ersten Innenfläche (17) ein erster Winkel (α) aufgespannt ist,
**dadurch gekennzeichnet,**
**dass** die erste Innenfläche (17) an die vom Aktuatorkopf (5) abgewandte Axialseite (16) der Haltekörperkontaktfläche (20) sowie die erste Aktuatorfußfläche (12) an die vom Aktuatorkopf (5) abgewandte Axialseite (16) der Aktuatorfußkontaktfläche (14) anschließen.

2. Injektor nach Anspruch 1,
**dadurch gekennzeichnet,**
**dass** die piezoelektrische Aktuatoreinheit (2) in einem Niederdruckbereich des Injektors (1) angeordnet ist.

3. Injektor nach einem der Ansprüche 1 oder 2,
**dadurch gekennzeichnet**,
die Aktuatorfußkontaktfläche (14) und die Haltekörperkontaktfläche (20) linienförmig, insbesondere kreislinienförmig ausgebildet sind.

4. Injektor nach einem der vorhergehenden Ansprüche,
**dadurch gekennzeichnet,**
**dass** sich die erste Aktuatorfußfläche (12) und/oder die erste Innenfläche (17) konisch verjüngen/verjüngt.

5. Injektor nach einem der vorhergehenden Ansprüche,
**dadurch gekennzeichnet,**
**dass** der Aktuatorfuß (4) eine zweite axial an die Aktuatorkontaktfläche (14) angrenzende Aktuatorfußfläche (11) aufweist und dass der Haltekörper (3) eine zweite axial an die Haltekörperkontaktfläche (20) angrenzende Innenfläche (18) aufweist.

6. Injektor nach Anspruch 5,
**dadurch gekennzeichnet,**
**dass** sich die zweite Aktuatorfußfläche (11) und/oder die zweite Innenfläche (18) konisch verjüngen/verjüngt.

7. Injektor nach einem der Ansprüche 5 oder 6,
**dadurch gekennzeichnet,**
**dass** die zweite Innenfläche (18) auf der dem Aktuatorkopf (5) zugewandten Axialseite (15) der Haltekörperkontaktfläche (20) und die zweite Aktuatorfußfläche (11) auf der dem Aktuatorkopf (5) zugewandten Axialseite (15) der Aktuatorfußkontaktfläche (14) angeordnet sind.

8. Injektor nach einem der Ansprüche 5 bis 7,
**dadurch gekennzeichnet,**
**dass** die zweite Aktuatorfußfläche (11) mit der Längsmittelachse (L) der piezoelektrischen Aktuatoreinheit (2) einen spitzeren Winkel einschließt als die erste Aktuatorfußfläche (12) mit der Längsmittelachse (L) der piezoelektrischen Aktuatoreinheit (2) und/oder dass die erste Innenfläche (17) einen spitzeren Winkel mit der Längsmittelachse (L) der piezoelektrischen Aktuatoreinheit (2) einschließt als die zweite Innenfläche (18) mit der Längsmittelachse (L) der piezoelektrischen Aktuatoreinheit (2).

9. Injektor nach einem der vorhergehenden Ansprüche,
**dadurch gekennzeichnet,**
**dass** der erste Winkel (α) aus einem Bereich zwischen etwa 5° und etwa 15° gewählt ist, vorzugsweise etwa 10° beträgt und/oder dass der zweite Winkel (β) aus einem Bereich zwischen etwa 25° und etwa 45° gewählt ist, vorzugsweise etwa 35° beträgt.

10. Montageverfahren zur Montage eines Injektors, insbesondere mit den Merkmalen eines der orhergehenden Ansprüche, mit einer piezoelektrischen Aktuatoreinheit (2) mit einem Aktuatorfuß (4), der sich mit einer Aktuatorfußkontaktfläche (14) an einer Haltekörperkontaktfläche (20) eines Haltekörpers (3) abstützt,
**dadurch gekennzeichnet,**
**dass** Haltekörper (3) und Aktuatorfuß (4) mit einer Anpresskraft (F) aneinander gepresst werden, die größer ist als die auf den Aktuatorfuß (4) in Richtung des Haltekörpers (3) wirkende maximale Betriebskraft.
